Europäisches Patentamt

European Patent Office

Office européen des brevets

(19)

(11) Veröffentlichungsnummer: **0 453 785 A1**

## (12) EUROPÄISCHE PATENTANMELDUNG

(21) Anmeldenummer: 91104653.0

(51) Int. Cl.⁵: **H01L 21/70**

(22) Anmeldetag: 25.03.91

(30) Priorität: 24.04.90 CH 378/90

(43) Veröffentlichungstag der Anmeldung:
30.10.91 Patentblatt 91/44

(84) Benannte Vertragsstaaten:
AT BE CH DE FR GB IT LI NL SE

(71) Anmelder: Oerlikon-Contraves AG
Schaffhauserstrasse 580
CH-8052 Zürich(CH)

(72) Erfinder: Brändli, Gerold, Dr.
Schanzmättelistrasse 27
CH-5000 Aarau(CH)
Erfinder: Bachmann, Guido
Hubelweid 4
CH-6204 Sempach(CH)

(74) Vertreter: Hunziker, Kurt
c/o Werkzeugmaschinenfabrik
Oerlikon-Bührle AG Birchstrasse 155
CH-8050 Zürich(CH)

(54) Verfahren zur Herstellung von mehrlagigen Dünnschichtschaltungen mit integrierten Dünnschichtwiderständen.

(57) Nach dem erfindungsgemässen Verfahren können in mehrlagige Dünnschichtschaltungen, die durch abwechselndes Aufbauen von Leiterlagen (1/2/3, 1'/2'/3'...) und Isolierschichten (5, 5'...) hergestellt werden, Dünnschichtwiderstände (10) integriert werden, die direkt auf dem Substrat (S) liegen, aber trotzdem bei der Herstellung nicht den hohen Temperaturen der Aushärtung der Isolierschichten (5, 5'...) ausgesetzt und damit beschädigt werden. Das Verfahren erlaubt es auch, integrierte Kontaktierungen zwischen den Dünnschichtwiderständen (10) und Leitern aus allen Leiterlagen herzustellen.

FIG. 2

EP 0 453 785 A1

Die Erfindung liegt auf dem Gebiete der Leiterplattenherstellung und betrifft ein Verfahren gemäss dem Oberbegriff des Patentanspruchs 1, mit dem zwei- oder mehrlagige Dünnschichtschaltungen mit integrierten, trimmbaren Dünnschichtwiderständen hergestellt werden können.

Verfahren zur Herstellung von mehrlagigen Dünnschichtschaltungen sind bekannt zum Beispiel aus der Europäischen Patentanmeldung 0 286 854 (Verfahren zum Herstellen einer mehrlagigen Dünnschichtschaltung). Dieses Verfahren wird hier als bekannt vorausgesetzt.

Mehrlagige Dünnschichtschaltungen weisen heute sehr hohe Leiterbahnendichten und dadurch kurze Verbindungen auf. Erfordert zum Beispiel ein Schaltkreis grosse Speiseströme, die über kurze, breite Leitungen geführt werden müssen, und hohe Leiterbahndichte, wird man vorteilhaft eine mehrlagige Dünnschichtschaltung verwenden. Kommen nun aber als zusätzliche Forderungen genaue, trimmbare Widerstände hinzu, muss eine andere Technik oder eine Mischtechnik angewendet werden, denn in mehrlagige Dünnschichtschaltungen lassen sich bis anhin aus den folgenden Gründen keine Dünnschichtwiderstände integrieren:

- Werden die Widerstände in der dem wärmeableitenden Substrat am nächsten, untersten Lage der Dünnschichtschaltung integriert, müssen nachher darüber eine oder mehrere Isolationsschichten erstellt und bei für den Widerstandswerkstoff zu hohen Temperaturen ausgehärtet werden (z.B. Imidisierung von Polyimidschichten bei 300 bis 400 $^\circ$ C).
- Werden die Widerstände in der zweiten oder einer weiteren Lage integriert, sind sie durch mindestens eine Isolationsschicht vom wärmeabführenden Substrat getrennt und können deshalb nicht so belastet werden, wie es bei einer direkten Wärmeabführung durch das Substrat möglich wäre.

Die Anwendungen aber, für die eine solche Kombination von mehrlagigen Dünnschichtschaltungen mit Dünnschichtwiderständen vorteilhaft wären, sind zahlreich. Ein Beispiel dafür sind schnelle Analog/Digitalwandler. Der analoge Teil braucht genaue, trimmbare Widerstände, der digitale Teil benötigt eine hohe Verbindungsdichte und die schnellen Bausteine insgesamt grosse Speiseströme.

Vorteilhaft wäre ein Verfahren, mit dessen Hilfe Dünnschichtwiderstände in mehrlagige Dünnschichtschaltungen so integriert werden können, dass sie einer so hohen Strom-Belastung ausgesetzt werden können, wie es der Widerstandswerkstoff bei ausreichender Wärmeabführung zulässt. Dazu müsste man die Dünnschichtwiderstände direkt auf das wärmeableitende Substrat aufsetzen können, ohne sie nachher einem darauffolgenden, schädigenden Verfahrensschritt unterziehen zu müssen.

Ein solches Verfahren ist im Patentanspruch 1 definiert und wird nun anhand eines Beispiels detailliert beschrieben.

Dieses Verfahren basiert darauf, dass bei der Herstellung der unteren, dem Substrat näheren Lagen der mehrlagigen Dünnschichtschaltung Zonen gebildet werden, in denen nach den schädigenden Verfahrensschritten, bspw. erst mit der Herstellung der obersten, vom Substrat am weitesten entfernten Lage Dünnschichtwiderstände erstellt werden. Diese liegen in diesen Zonen direkt auf dem Substrat und können, falls erforderlich, nachträglich getrimmt werden.

Zur Illustration der detaillierten Beschreibung des erfindungsgemässen Verfahrens dienen die folgenden Figuren. Sie zeigen:

Fig. 1: einen typischen Verfahrensablauf für das erfindungsgemässe Verfahren und

Fig. 2: ein Beispiel eines nach dem erfindungsgemässen Verfahren hergestellten, in eine dreilagige Dünnschichtschaltung integrierten Dünnschichtwiderstandes.

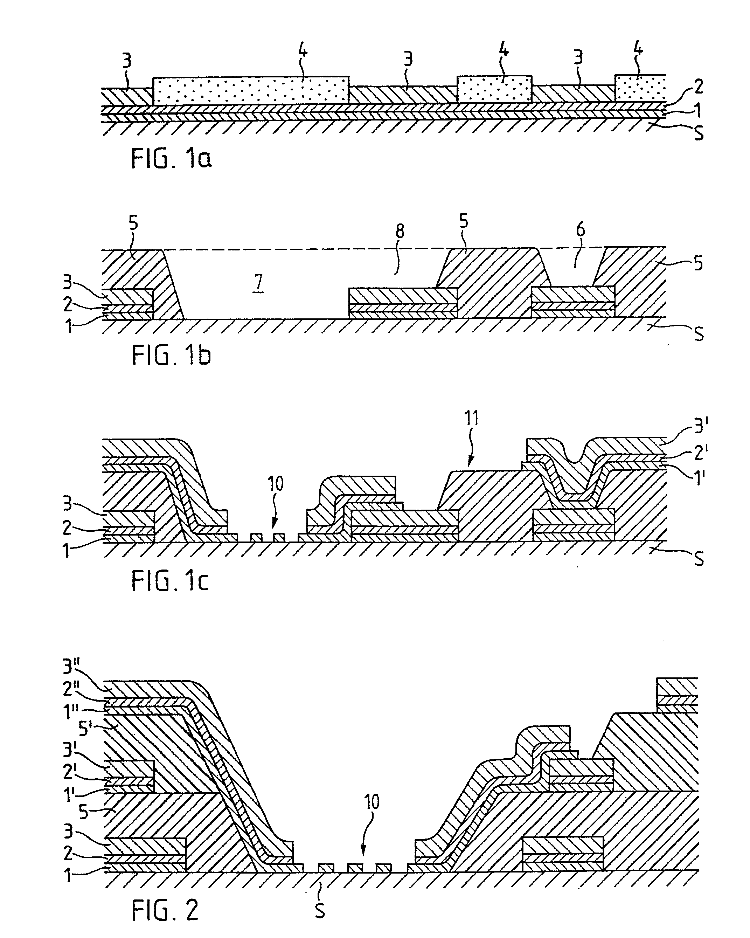

Figur 1 zeigt die Hauptschritte des erfindungsgemässen Verfahrens am Beispiel einer zweilagigen Dünnschichtschaltung:

1a: Auf ein Keramiksubstrat S wird nach bekannten Methoden eine erste Leiterlage aufgebracht. Zum Beispiel wird ganzflächig eine Haftschicht 1 gesputtert aus einem oxydationsfreudigen Metall (bspw. Cr, Ti, W, Al, NiCr). Auf die Haftschicht 1 wird ganzflächig eine Leitschicht 2 (bspw. aus Cu, Ni) gesputtert. Über dieser Leitschicht 2 wird eine Schicht Photolack 4 angebracht und auf photolithographischem Wege zum gewünschten Leiterbild dieser Leiterlage strukturiert. Darauf werden die Leiterbahnen 3 (bspw. aus Cu, Au) selektiv galvanisch aufgebracht.

1b: Die Photolackschicht 4 wird entfernt. Die nun freigelegten Teile der Leitschicht 2 werden mit einem dem Material dieser Schicht angepassten Ätzmittel weggeätzt. Die dadurch freigelegten Teile der Haftschicht 1 werden dann mit einem dem Material dieser Haftschicht angepassten Ätzmittel weggeätzt. Die ganze erste Leiterlage wird nun mit einer Isolierschicht 5 (z.B. aus negativ-photosensitivem Polyimid) bedeckt. Durch eine dem Material der Isolierschicht entsprechende Methode (z.B. UV-Belichtung durch eine Photomaske und anschliessende Entwicklung) wird die Isolierschicht strukturiert. Die Isolierschicht wird überall dort entfernt, wo Durchkontaktierungen zwischen der bereits erstellten und der darüber liegenden Leiterlage hergestellt werden sollen (Stellen 6) und neu, gemäss dem erfindungsgemässen Verfahren dort, wo für Dünnschichtwiderstände Fenster (Zonen) offengehalten werden sollen (Stellen 7), und dort, wo die zu erstellenden Dünnschichtwiderstände mit Leitern der untersten Lage kontaktiert werden sollen (Stellen 8). Nun wird die Isolierschicht 5 bei der adäquaten Temperatur polymerisiert. An Stelle photoaktiver Polyimide lassen sich andere Materialien für die Isolierschichten 5 verwenden, wie zum trockenätzen geeignete Polyimide oder Benzocyclobuten, Polyphenylquinoxalin oder verwandte Materialien. Dabei wird die Isolierschicht zunächst polymerisiert bzw. mit bis zu 400° C gehärtet, mit strukturiertem Aetzresist nach einer gängigen Variante maskiert, anschliessend im Plasma trockengeäzt und schliesslich die Maskierung entfernt.

1c: Eine zweite Leiterlage wird aufgebracht, indem in analoger Weise, wie im Zusammenhang mit Figur 1a beschrieben, eine Haftschicht 1' zum Beispiel aus NiCr oder TaN und eine Leitschicht 2' ganzflächig gesputtert werden. Die Haftschicht 1' liegt in den im ersten Arbeitsgang offen gelassenen Fenstern direkt auf dem Substrat S und wird dort die Dünnschichtwiderstände 10 bilden. Weiter wird eine Photoresistschicht aufgebracht (in der Figur nicht sichtbar), gemäss den gewünschten Leiterbahnen dieser zweiten Leiterlage strukturiert, die Leiterbahnen 3' galvanisch aufgebracht und die Photoresistschicht entfernt. Die Leiterbahnen der zweiten Leiterlage kontaktieren die Leiterbahnen der ersten Leiterlage: an Stellen 6, wo Kontaktierungszonen durch die Isolierschicht 5 hindurch vorgesehen wurden, und an Stellen 8, wo Kontaktierungen der ersten (unteren) Leiterlage mit den Dünnschichtwiderständen 10 vorgesehen sind. Nach dem Aufbau der Leiterbahnen 3' der zweiten Leiterlage wird die dazu aufgetragene Photolackschicht entfernt und die freigelegten Teile der Leitschicht 2' wegeätzt. Vor dem Wegätzen der nun freigelegten Teile der Haftschicht 1' (Zonen 7 und 11) wird erneut eine Photolackschicht (in der Figur ebenfalls nicht sichtbar) aufgebracht, in die die Widerstandsstrukturen (Zone 7) eingebracht werden. Dies sind vorteilhafterweise trimmbare Muster, die nachträglich mit Laser fei ngetrimmt werden können. Die Haftschicht 1' wird dann geätzt, wodurch die Dünnschichtwiderstände 10 entstehen.

Typische Dicken der nach dem beschriebenen Verfahren hergestellten Schichten sind: 0,01μm für die Haftschichten 1 oder 1', 0,2μm für die Leitschichten 2 oder 2' und 5μm für die Leiterbahnen 3 oder 3'.

Der in der Figur 1c abgebildete Dünnschichtwiderstand 10 ist in der Figur auf der linken Seite mit einem Leiter der zweiten (oberen) Leiterlage, auf der in der Figur rechten Seite mit einem Leiter der ersten (unteren) Leiterlage verbunden, zwischen welchen Leitern der Widerstand nun eingestellt werden kann. In analoger Weise können entsprechende Fenster erstellt werden mit Dünnschichtwiderständen, die mit anderen Leiterlagen kontaktiert sind, bspw. beidseitig mit der zweiten (oberen) Leiterlage. Falls erwünscht, kann zum Schluss noch eine Schutzschicht über alles appliziert werden.

Mit demselben Verfahren lassen sich in der beschriebenen Weise auch mehr als zweilagige Dünnschichtschaltungen herstellen, wobei die Dünnschichtwiderstände immer mit der obersten, vom Substrat am weitesten entfernten, Leiterlage, die zuletzt aufgebaut wird, entstehen, aber mit Leitern aus irgend einer der Leiterlagen kontaktiert sein können.

Figur 2 zeigt eine entsprechende Anordnung einer dreilagigen Dünnschichtschaltung. Der Dünnschichtwiderstand 10 ist in diesem Falle als Teil der Haftschicht 3'' der dritten (obersten) Leiterlage entstanden, wobei die dritte Leiterlage nach den im Zusammenhang mit Figur 1c beschriebenen Verfahrensschritten hergestellt wird. Der abgebildete Dünnschichtwiderstand ist auf der in der Figur linken Seite mit der dritten (obersten) Leiterlage, auf der in der Figur rechten Seite mit der zweiten (mittleren) Leiterlage kontaktiert. Das Fenster durchbricht beide Isolierschichten 5 und 5'.

Auch im Falle von mehr als zweilagigen Dünnschichtschaltungen können mit dem erfindungsgemässen Verfahren Dünnschichtwiderstände erstellt werden, die mit irgend einer der Leiterlagen kontaktiert sind.

Ähnliche Fenster wie für Dünnschichtwiderstände können in mehrlagigen Dünnschichtschaltungen auch offen gelassen und dann mit Komponenten, die im Betrieb viel Abwärme erzeugen, bestückt werden. Auch für Bonddrähte und andere Verbindungen zwischen Komponenten und Leitern der unteren Leiterlagen können solche Fenster erstellt werden.

## Patentansprüche

1. Verfahren zur Herstellung von mehrlagigen Dünnschichtschaltungen mit integrierten Dünnschichtwiderständen, bei dem die übereinanderliegenden Leiterlagen in nacheinander durchgeführten Verfahrensschritten auf das Substrat aufgebaut werden, dadurch gekennzeichnet, dass in allen Isolierschichten (5, 5'...) und in allen Leiterlagen ausser der zuletzt erstellten, vom Substrat (S) am weitesten entfernten Leiterlage, freie Zonen (7) gebildet werden, in denen in einem Verfahrensschritt nach allen Verfahrensschritten zur thermischen Behandlung von Isolierschichten (5, 5'...) Dünnschichtwiderstände (10) derart erstellt werden, dass sie direkt auf dem Substrat (S) liegen und nachträglich bearbeitbar sind.

2. Verfahren nach Anspruch 1, dadurch gekennzeichnet, dass die Erstellung der letzten, vom Substrat am weitesten entfernten Leiterlage in den folgenden Verfahrensschritten abläuft:
   a) Erstellen einer ganzflächigen Haftschicht (1') aus einem für Dünnschichtwiderstände geeigneten Material;
   b) Erstellen einer ganzflächigen Leitschicht (2');
   c) Aufbringen einer Photolackschicht (4') und Strukturierung dieser Photolackschicht gemäss der gewünschten Leiterstruktur dieser Leiterlage;
   d) Erstellen der Leiter (3');
   e) Entfernen der Photolackschicht (4');
   f) Wegätzen der freigelegten Teile der Leitschicht (2');
   g) Aufbringen einer weiteren Photolackschicht und Strukturieren dieser Photolackschicht gemäss der gewünschten Struktur der Dünnschichtwiderstände (10) und ihren Kontaktierungen zu den bereits erstellten Leiterlagen;
   h) Ätzen der Haftschicht (1'), und
   i) Entfernen der zweiten Photolackschicht.

3. Verfahren nach einem der Ansprüche 1 oder 2, dadurch gekennzeichnet, dass durch entsprechende Strukturierung der Isolierschichten (5, 5'...) zwischen den Leiterlagen und entsprechende Strukturierung der zuletzt erstellten Leiterlage integrierte Verbindungen hergestellt werden zwischen den Dünnschichtwiderständen (10) und Leitern aus anderen Leiterlagen.

4. Verfahren nach einem der Ansprüche 1 bis 3, dadurch gekennzeichnet, dass für die Isolierschichten (5, 5'...) photoaktives Polyimid verwendet wird.

5. Verfahren nach einem der Ansprüche 1 bis 3, dadurch gekennzeichnet, dass für die Isolierschichten (5, 5', ..) trockenätzbares Polyimid, Benzocyclobuten oder Polyphenylquinoxalin verwendet wird.

6. Verfahren nach Anspruch 1, dadurch gekennzeichnet, dass die freien Zonen (7) zusätzlich zu Dünnschichtwiderständen (10) mit anderen Komponenten, die viel Abwärme produzieren, bestückt werden.

7. Erzeugnis hergestellt mit dem Verfahren gemäss einem der Ansprüche 1 bis 6.

FIG. 1a

FIG. 1b

FIG. 1c

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 079 345  (FUJITSU LTD.)<br>– – – | | H 01 L 21/70 |
| A | US-A-4 496 435  (NEC CORPORATION)<br>– – – – – | | |

| RECHERCHIERTE SACHGEBIETE (Int. Cl.5) |
|---|
| H 01 L |

Der vorliegende Recherchenbericht wurde für alle Patentansprüche erstellt

| Recherchenort | Abschlußdatum der Recherche | Prüfer |
|---|---|---|
| Den Haag | 06 August 91 | PELSERS L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

-----------------------------------------------------------------

& : Mitglied der gleichen Patentfamilie, übereinstimmendes Dokument